Europäisches Patentamt

(19) European Patent Office

Office européen des brevets

(11) Veröffentlichungsnummer: **0 009 821**

A1

(12) # EUROPÄISCHE PATENTANMELDUNG

(21) Anmeldenummer: 79103845.8

(22) Anmeldetag: 08.10.79

(51) Int. Cl.³: **G 01 G 23/44**
**G 01 G 1/29, H 03 K 13/00**

(30) Priorität: **10.10.78 DE 2844074**

(43) Veröffentlichungstag der Anmeldung:
**16.04.80 Patentblatt 80/8**

(84) Benannte Vertragsstaaten:
**CH FR GB**

(71) Anmelder: **Sartorius GmbH.**
**Weender Landstrasse 94-108**
**D-3400 Göttingen(DE)**

(72) Erfinder: **Knothe, Erich**
**Hasenwinkel 4**
**D-3406 Bovenden 1(DE)**

(72) Erfinder: **Melcher, Franz-Josef**
**Rosenwinkel 18**
**D-3414 Hardegsen 3(DE)**

(72) Erfinder: **Oldendorf, Christian**
**Stettiner Strasse 18**
**D-3400 Göttingen(DE)**

(74) Vertreter: **Köhler, Rudolf**
**c/o Sartorius GmbH Weender Laudstrasse 94-108**
**D-3400 Göttingen(DE)**

(54) Abtastanordnung für den Codeträger einer Schaltgewichtseinrichtung in einer Waage zur Erweiterung des Wägebereichs.

(57) Abtastanordnung für den Codeträger (6) einer Schaltgewichtseinrichtung in einer Waage zur Erweiterung des Wägebereichs, wobei der Codeträger die Stellung der Schaltgewichtseinrichtung analog anzeigt und in Abhängigkeit von den möglichen Schaltstellungen mehrere nebeneinanderliegende Codespuren (S 1 bis S 5) aufweist, die in magnetoelektronisch und/oder optoelektronisch wirksame und unwirksame Abschnitte (7,8) unterteilt sind und mit einer aus mehreren Sender-Empfänger-Einheiten (1,1' bis 5,5') aufweisenden Abtastung korrespondieren, welche an eine Anzeige und/oder Steuereinrichtung angeschlossen ist.

Um die bei der Miniaturisierung der Abtastanordnungen auftretenden Probleme der störenden Überlagerung der Sender-Empfänger-Signale benachbarter Codespuren zu lösen, sind die den einzelnen Codespuren (S 1 bis S 5) zugeordneten Sender-Empfänger-Einheiten (1,1' bis 5,5') in Längsrichtung der Codespuren (S 1 bis S 5) versetzt zueinander angeordnet und die magnetoelektronisch und/oder optoelektronisch wirksamen und unwirksamen Abschnitte (7,8) der jeweiligen Codespuren sind in entsprechender Weise zueinander versetzt.

./...

EP 0 009 821 A1

*Fig.1*

- 1 -

SARTORIUS GMBH                          Akte SW 7807-EU

Weender Landstraße 94-108               Kö/kl

3400 Göttingen

Abtastanordnung für den Codeträger einer Schaltgewichtseinrichtung in einer Waage zur Erweiterung des Wägebereichs

Die Erfindung betrifft eine Abtastanordnung für den Codeträger einer Schaltgewichtseinrichtung in einer Waage zur
Erweiterung des Wägebreichs, wobei der Codeträger die Stellung der Schaltgewichtseinrichtung analog anzeigt und in Abhängigkeit von den möglichen Schaltstellungen mehrere nebeneinanderliegende Codespuren aufweist, die in magnetoelektronisch und/oder optoelektronisch wirksame und unwirksame
Abschnitte unterteilt sind und mit einer aus mehreren Sender-Empfänger-Einheiten aufweisenden Abtastung korrespondieren, welche an eine Anzeige und/oder Steuereinrichtung
angeschlossen ist.

SW 7807-EU — 2 —

0009821

Einrichtungen dieser Art dienen beispielsweise dazu die durch Nockenscheiben betätigten Schaltgewichte von Analysenwaagen in ihrer jeweiligen Schaltstellung anzuzeigen. Diese Nockenscheiben werden dabei entweder manuell oder motorisch angetrieben. Der scheibenförmige Codeträger hat dabei die Aufgabe, die genaue Stellung der einzelnen Nockenscheiben und damit die aufliegende oder abgehobene Position eines bestimmten Schaltgewichtes bzw. eines Schaltgewichtpaares anzuzeigen, damit im Bedarfsfall durch Vorwärts- oder Rückwärtsschalten der Nockenwelle das eine oder andere Gewichtspaar dazu oder weggeschaltet werden kann.

Als Sender-Empfänger-Einheiten kommen dabei kleine elektronische Bauteile zur Anwendung, die aufgrund ihrer Baugröße weitgehend die Größe der Abtasteinrichtung bestimmen. Dabei ist es üblich, daß sowohl bei linealförmigen Codeträgern als auch bei kreisrunden Codeträgern die Sender-Empfänger-Einheiten in einer Linie angeordnet sind und damit den Abstand der Codespuren untereinander festlegen. Da für solche Abtastvorrichtungen in Meßgeräten, insbesondere aber in Waagen für den eingangs genannten Zweck, der vorhandene Raum sehr begrenzt ist, werden die kleinstmöglichen Abmessungen des Codeträgers und der gesamten Abtasteinrichtung von diesen Sender-Empfänger-Einheiten bestimmt, wobei sich die Breite des Codeträgers aus den aneinandergereihten Sender-Empfänger-Einheiten ergibt.

Bei einer Abtastanordnung nach dem Oberbegriff (DE-AS 1224970) besitzt diese für die erste Codespur e i n e Sender-Empfänger-Einheit und für die witeren Codespuren je z w e i Sender-Empfänger-Einheiten. Diese Sender-Empfänger-Einheiten sind V-förmig angeordnet und ihre geometrische Position zueinander ergibt sich aus dem Schrittabstand des Codes. Ziel dieser Ausbildung ist die Lösung der Probleme der fehlerfreien Abtastung an Code-Übergängen.

Weiterhin ist bekannt (DE-AS 2263619) den Codeträger kreisrund auszubilden, wobei die magnetischen Codespuren auf konzentrischen Kreisen angeordnet und die Sender-Empfänger-Einheiten auf einer radialen Linie angeordnet sind und aus Hallgeneratoren bestehen.

Ähnlich aufgebaut ist eine elektro-optische Abtasteinrichtung nach der CH-PS 503263, bei der ebenfalls ein kreisrunder Codeträger zur Anwendung gelangt, bei dem die Codespuren ebenfalls aus konzentrischen Kreisen bestehen und diese in mehr oder weniger große Segmente unterteilt sind, welche aus durchbrochenen und nichtdurchbrochenen Segmenten bestehen. Die aus Forozellen bestehenden Sender-Empfänger-Einheiten sind ebenfalls auf einer radial angeordneten Indexlinie angeordnet.

Der Nachteil dieser Abtasteinrichtung ist darin zu sehen, daß die Signale von benachbarten Sender-Empfänger-Einheiten sich aufgrund der gedrängten Anordnung der Bauteile überlagern bzw. stören, da die Signale, seien sie opto-elektronisch oder magneto-elektronisch, streuen bzw. vom Codeträger fehlerhaft reflektiert werden. Die Folge davon ist, daß Fehlimpulse empfangen werden und diese an die Steuereinrichtung für die Betätigung der Nockenwelle weitergegeben werden, so daß es zu Fehlschaltungen und damit Fehlanzeigen bei diesen hochempfindlichen Waagen kommt. Es ist auch bereits versucht worden diesen Mangel dadurch zu beheben, daß benachbarte Sen-

SW 7807-EU

- 4 -

0009821

der-Empfänger-Einheiten in opto-elektronischer Ausführung mit unterschiedlichen Empfindlichkeiten in einer Reihe anzuordnen. Dies hat jedoch ebenfalls nicht zu befriedigenden Ergebnissen geführt. Die Fehlsteuerungen konnten zwar dadurch reduziert werden, ließen sich jedoch nicht gänzlich ausschalten. Hinzu kommt, daß dadurch die Schaltung aufwendig und kompliziert wird und aufgrund der Lagerhaltung der verschiedenen Bauteile die Bestückung der Platinen für die Abtastung schwierig ist.

Der Erfindung liegt daher die Aufgabe zugrunde, bei einer Waage der eingangs genannten Gattung die Ableseeinrichtung mit einfachen Mitteln so zu verbessern, daß trotz kleiner Ausbildung von Ablesekopf und Codeträger sich die Sender-Empfänger-Signale der einzelnen Sender-Empfänger-Einheiten nicht störend überlagern, sondern exakt voneinander getrennt geführt sind, d.h. die bei der Miniaturisierung der Abtastanordnungen auftretenden Probleme der störenden Überlagerung der Sender-Empfänger-Signale benachbarter Codespuren sind zu lösen.

Diese Aufgabe wird dadurch gelöst, daß für die einzelnen Codespuren die jeweiligen Sender-Empfänger-Einheiten und der zugehörige Code versetzt gegeneinander angeordnet sind. Dadurch ergibt sich trotz geringem Abstand der Codespuren ein großer Abstand der Sender-Empfänger-Einheiten und damit keine störende Überlagerung der verschiedenen Signale. Die Größe des Versatzes ist unabhängig vom Schrittabstand des Code und kann rein nach geometrisch-konstruktiven Gesichtspunkten gewählt werden.

Weiterhin wird im Gegensatz zu den vorgenannten Abtastanordnungen pro Codespur nur eine Sender-Empfänger-Eonheit benötigt.

Weitere vorteilhafte Ausbildung sind in den Unteransprüchen
unter Schutz gestellt.

Der Erfindungsgedanke, der die verschiedensten Ausführungsmöglichkeiten zuläßt ist in einem Ausführungsbeispiel anhand der beiliegenden Zeichnung näher erläutert. Dabei
zeigt:

Figur 1 in perspektivischer Darstellung als Explosionszeichnung die Abtastanordnung einer Waage und
Figur 2 die Abtastanordnung gemäß Fig. 1 schematisch im
        zusammengebauten Zustand.

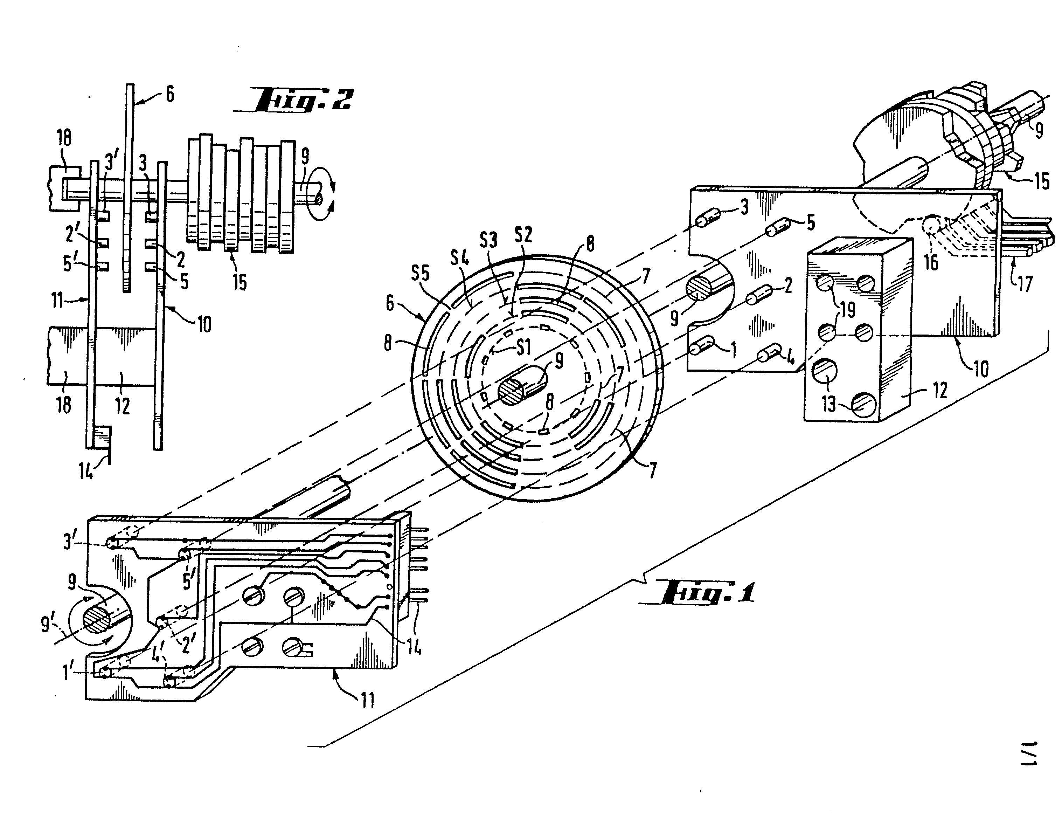

Die dargestellte Abtastanordnung ist Teil einer Gewichtsschaltung, beispielsweise einer Analysenwaage mit der der
Wägebereich durch die Gewichtsschaltung subtituierend erweitert werden kann. Die Gewichtsschalteinrichtung als solche und ebenso die elektronische Schaltung ist als solche
bekannt und nicht Gegenstand der vorliegenden Erfindung.

Die Abtastanordnung besteht im wesentlichen aus der Senderplatine 10, der Empfängerplatine 11, dem Abstandhalter 12
und dem zwischen beiden Platinen 10,11 umlaufenden Codeträger 6, der auf der Nockenwelle 9 für die Schaltnocken 15
befestigt ist. Die Schaltnocken 15 arbeiten zusammen mit zugeordneten Abtasthebeln 17, deren Laufrollen 16 auf den
Außenrändern der Nockenscheiben 15 abrollen und damit je
nach Stellung Schaltgewichte abheben oder absenken. Um die
genauen Schaltstellungen der einzelnen Schaltnocken 15 genau abtasten zu können, ist der Codeträger 6 in Form einer kreisrunden Scheibe mit konzentrisch angeordneten Codespuren S 1 bis S 5 versehen. Jede Codespur S 1 bis S 5 besteht aus Segmenten, die wiederum aus wirksamen und unwirksamen Abschnitten bestehen.

Im vorliegenden Ausführungsbeispiel gelangt eine opto-elektronische Abtastung zur Anwendung. Dies bedeutet, daß der Codeträger 6 in jeder Codespur S 1 bis S 5 Durchbrechungen 8 und undurchbrochene Spurenabschnitte 7 aufweist. Der Codeträger 6 besteht aus einer schwarzmattierten Metallscheibe, in welche die segmentförmigen Durchbrechungen 8 eingeätzt sind.

Im vorliegenden Beispiel sind auf der Senderplatine 10 fünf Senderdioden 1 bis 5 angeordnet, welche mit entsprechend angeordneten Empfängerdioden 1' bis 5' korrespondieren.

Wie aus dem Codeträger 6 erkennbar ist, ist dieser in 9 gleiche Sektoren von 40° eingeteilt, so daß jede Codespur S 1 bis S 5 ebenfalls in 9 Segmente unterteilt ist. Die Codespur S 1 bildet die sog. Statusspur, wodurch bei Verwendung von 8 Nockenscheiben 8 Nockenschaltstellungen und eine zusätzliche Ein-/Ausstellung genau angezeigt werden kann. Die Codespur S 2 bildet eine sog. Parity-bit-Spur, während die Codespuren S 3 bis S 5 Diodenspuren sind, mit denen die Schaltstellungen der 8 Nockenscheiben zusätzlich angezeigt werden, damit der die Nockenwelle 9 antreibende Schaltmotor zur Erreichung einer nächstmöglichen Schaltstellung auf dem kürzesten Wege vorwärts oder rückwärts geschaltet werden kann.

Aus beiden Darstellungen ist erkennbar, daß die Sender-Empfänger-Einheiten 1,1' bis 5,5' in Längsrichtung der einzelnen

Codespuren S 1 bis S 5 versetzt angeordnet sind, so daß diese untereinander einen ausreichenden Abstand aufweisen und sich nicht gegenseitig durch Streulicht oder reflektierende Signale beeinflussen können und zwar unter Verkleinerung der Gesamtanordnung. In entsprechender Weise sind die wirksamen und unwirksamen Abschnitte 7,8 der jeweiligen Codespuren S 1 bis S 5 zueinander versetzt angeordnet. So trifft beispielsweise die Sender-Empfänger-Einheit 1,1' in der Codespur S 1 auf eine Durchbrechung 8 und die Sender-Empfänger-Einheit 3,3' in der Codespur S 3 ebenfalls auf eine Durchbrechung 8, so daß einwandfrei die Schaltstellung eines der Schaltnocken 15 exakt angegeben ist. Die anderen Sender-Empfänger-Einheiten 2,2', 4,4', 5,5' treffen auf den Codespuren S 2, S 4, S 5 auf Reflektorstellen 7 der Codescheibe 6.

Auf der Empfängerplatine 11 sind schematisch die Schaltkreise 14 angeordnet, welche mit Hilfe von Steckkontakten an den zugeordneten Steuerteil der Waage anschließbar sind. Auf der Senderplatine 10 sind auf der Rückseite ebenfalls Schaltkreise aufgedruckt, die mit den elektronischen Bauelementen und weiteren nicht dargestellten elektronischen Bauelementen auf der hier sichtbaren Vorderseite zusammenarbeiten. Mit Hilfe der Abstandhalter 12 sind die Sender- und Empfängerplatine 10,11 an den Befestigungspunkten 19 miteinander verbunden und mit Hilfe der Befestigungspunkte 13 an Festpunkten 18 der Waage gehalten. In gleicher Weise ist die in der Achse 9' verlaufende Nockenwelle 9 in Festpunkten 18 bzw. mit dem nicht dargestellten Schaltmotor bzw. einem von Hand zu betätigenden Schaltrad verbunden.

Das gleiche Prinzip ist anwendbar für linealmäßig aufgebaute Codeträger. Hierbei sind die parallel zueinander verlaufenden Codespuren in Abschnitte unterteilt, wobei benachbarte Sender-Empfänger-Einheiten mit einem wirksamen Abstand in Längsrichtung der Codespuren versetzt oder mit mehreren Codespuren-Abstand voneinander angeordnet sind. Nach dem selben Prinzip kann die Ableseeinrichtung auch nach dem magnetisch-elektronischen Sender-Empfänger-Prinzip aufgebaut sein. Auch hierbei sorgen die längs den Codespuren versetzt angeordneten Sender-Empfänger-Einheiten nicht gegenseitig störend beeinflussen.

Patentansprüche

1. Abtastanordnung für den Codeträger einer Schaltgewichtseinrichtung in einer Waage zur Erweiterung des Wägebereichs, wobei der Codeträger die Stellung der Schaltgewichtseinrichtung analog anzeigt und in Abhängigkeit von den möglichen Schaltstellungen mehrere nebeneinanderliegende Codespuren aufweist, die in magnetoelektronisch und/oder optoelektronisch wirksame und unwirksame Abschnitte unterteilt sind und mit einer aus mehreren Sender-Empfänger-Einheiten aufweisenden Abtastung korrespondieren, welche an eine Anzeige und/oder Steuereinrichtung angeschlossen ist, dadurch gekennzeichnet, daß die den einzelnen Codespuren (S 1 bis S 5) zugeordneten Sender-Empfänger-Einheiten (1,1' bis 5,5') in Längsrichtung der Codespuren (S 1 bis S 5) versetzt zueinander angeordnet sind und daß die magnetoelektronisch und/oder optoelektronisch wirksamen und unwirksamen Abschnitte (7,8) der jeweiligen Codespuren in entsprechender Weise zueinander versetzt sind.

2. Waage nach Anspruch 1, dadurch gekennzeichnet, daß bei Verwendung eines scheibenförmigen, runden Codeträger (6) die Codespuren S 1 bis S 5) auf konzentrischen Kreisbahnen angeordnet und in Segmente unterteilt und die Sender-Empfänger-Einheiten (1,1' bis 5,5') entsprechend sektormäßig versetzt zueinander angeordnet sind.

3. Waage nach Anspruch 1, dadurch gekennzeichnet, daß bei Verwendung eines Linealstabes als Codeträger die Sender-Empfänger-Einheiten in mehrere Codeträgerabschnitten angeordnet sind.

Fig.2

Fig.1

0009821

1/1

| Kategorie | Kennzeichnung des Dokuments mit Angabe, soweit erforderlich, der maßgeblichen Teile | betrifft Anspruch |
|---|---|---|
| | GB - A - 1 044 635 (STANDARD TELEPHONES AND CABLES LTD.) <br> * Seite 5, Zeilen 29-64; Figur 7b * <br><br> -- <br><br> DE - C - 1 154 560 (LICENTIA PATENT-VERWALTUNGS GmbH) <br> * Spalte 2, Zeilen 34-46; Figur 2 * <br><br> ---- | 1,2 <br><br><br><br><br> 1 |

**EINSCHLÄGIGE DOKUMENTE**

**KLASSIFIKATION DER ANMELDUNG (Int.Cl ³)**

G 01 G 23/44
1/29
H 03 K 13/00

**RECHERCHIERTE SACHGEBIETE (Int. Cl ³)**

G 01 G 1/29
1/38
13/32
23/36
23/44
G 08 C 9/00
9/04
9/06
G 01 D 5/36
H 03 K 13/00
G 01 G 23/37

**KATEGORIE DER GENANNTEN DOKUMENTE**

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patentfamilie, übereinstimmendes Dokument

Der vorliegende Recherchenbericht wurde für alle Patentansprüche erstellt

| Recherchenort | Abschlußdatum der Recherche | Prüfer |
|---|---|---|
| Den Haag | 17-01-1980 | VAN ASSCHE |